# EUROPEAN PATENT APPLICATION

(11) **EP 1 770 136 A2**
(43) Date of publication of application: **04.04.2007**
(21) Application number: 06121549.7
(22) Date of filing: 29.09.2006
(51) Int. Cl.: C09G 1/02, H01L 21/304

(54) **Polishing composition and polishing method**

(30) Priority: 30.09.2005 JP 2005289169
(71) Applicant: FUJIMI INCORPORATED, Nishibiwajima-cho, Kiyosu-shi Aichi 452-8502 (JP)
(72) Inventor: Ito, Takashi, Kiyosu-shi Aichi 452-8502 (JP); Kimura, Yoshio, Kiyosu-shi Aichi 452-8502 (JP)
(74) Representative: Viering, Jentschura & Partner

(57) **Abstract**

A polishing composition contains silica abrasive grains having an average particle size of 20 to 100 nm, an alkali selected from the group consisting of ammonia, ammonium salts, alkali metal salts, and alkali metal hydroxides, and a silicone oil having an HLB value greater than or equal to 8. The polishing composition is suitable for use in an application for polishing an object to be polished.

## Description

### BACKGROUND OF THE INVENTION

The present invention relates to a polishing composition which is used, for example, in an application for polishing an object to be polished comprising silicon dioxide such as SiO₂ film as an insulating film in a semiconductor circuit, and a polishing method using such a polishing composition.

A polishing composition used in an application for polishing an object to be polished comprising silicon dioxide such as SiO₂ film is required to have at least properties of causing few defects such as scratches resulting on the surface of an object to be polished when the object to be polished is polished using the polishing composition, and a high polishing rate (a high removal rate) for the object to be polished by the polishing composition. For example, a polishing composition improved for satisfying such requirements and containing silica abrasive grains such as fumed silica and a thickener such as polyacrylic resin is disclosed in Japanese Laid-Open Patent Publication No. 2001-271058. However, the polishing composition of Japanese Laid-Open Patent Publication No. 2001-271058 does not satisfy the requirements enough and has still room to be improved.

Meanwhile, a polishing composition containing a silicone surfactant such as polyoxyethylene methylpolysiloxane is disclosed in Japanese Laid-Open Patent Publication No. 2004-247605. However, the polishing composition of Japanese Laid-Open Patent Publication No. 2004-247605 is used in an application for polishing an object to be polished including an organic insulating film, and use in an application for polishing an object to be polished comprising silicon dioxide such as SiO₂ film is not aimed at.

### SUMMARY OF THE INVENTION

Accordingly, it is an objective of the present invention to provide a polishing composition suitable for use in an application for polishing an object to be polished comprising silicon dioxide and a polishing method using such a polishing composition.

To achieve the foregoing objectives and in accordance with a first aspect of the present invention, a polishing composition used in an application for polishing an object to be polished comprising silicon dioxide is provided. The polishing composition contains silica abrasive grains having an average particle size of 20 to 100 nm, an alkali selected from the group consisting of ammonia, ammonium salts, alkali metal salts, and alkali metal hydroxides, and a silicone oil having an HLB value greater than or equal to 8.

In accordance with a second aspect of the present invention, a polishing method including polishing an object to be polished comprising silicon dioxide using the polishing composition is provided.

Other aspects and advantages of the invention will become apparent from the following description, illustrating by way of example the principles of the invention.

### DETAILED DESCRIPTION OF THE PREFERRED EMBODIMENTS

Hereinbelow, an embodiment of the present invention is described.

A polishing composition according to this embodiment is produced by mixing silica abrasive grains, alkali, silicone oil, and water. Accordingly, the polishing composition substantially consists of silica abrasive grains, alkali, silicone oil, and water. The polishing composition is used in an application for polishing, for example, SiO₂ film as an insulating film of a semiconductor circuit.

Silica abrasive grains in the polishing composition play a role of mechanically polishing SiO₂ film and contribute to improving the polishing rate (removal rate) of SiO₂ film by the polishing composition.

Silica abrasive grains contained in the polishing composition are preferably fumed silica or colloidal silica, and more preferably they are fumed silica. When silica abrasive grains contained in the polishing composition are fumed silica or colloidal silica, scratches resulting on the surface of SiO₂ film when the SiO₂ film is polished using a polishing composition are reduced. In addition to the reduction of scratches, polishing rate of SiO₂ film by the polishing composition is significantly improved as well when silica abrasive grains contained in the polishing composition are fumed silica.

The average particle size of silica abrasive grains contained in the polishing composition is 20 to 100 nm. When the average particle size of silica abrasive grains contained in the polishing composition is less than 20 nm, not only polishing rate of SiO₂ film by the polishing composition is not significantly improved but also scratches resulting on the surface of SiO₂ film when the SiO₂ film is polished using a polishing composition increase. On the other hand, silica abrasive grains having an average particle size more than 100 nm are poor in dispersibility in the polishing composition and easy to be deposited. In addition, the surface roughness of SiO₂ film obtained by polishing it with a polishing composition may increase when the average particle size of silica abrasive grains contained in the polishing composition is more than 100 nm.

But when the average particle size of silica abrasive grains contained in the polishing composition is less than 25 nm, even if it is greater than or equal to 20 nm, polishing rate of SiO₂ film by the polishing composition is slightly in short, and scratches resulting on the surface of SiO₂ film increase a little. Therefore, it is preferable for improving the polishing rate and for reduction of scratches that the average particle size of silica abrasive grains contained in the polishing composition is greater than or equal to 25 nm. In addition, silica abrasive grains having an average particle size more than 75 nm are slightly poor in dispersibility in the polishing composition even if it is less than or equal to 100 nm. Therefore, it is preferable for the improvement of dispersibility of silica abrasive grains that the average particle size of silica abrasive grains contained in the polishing composition is less than or equal to 75 nm. The average particle size of silica abrasive grains is calculated by specific surface area of silica abrasive grains measured by BET method.

When the content of silica abrasive grains in the polishing composition is less than 1 % by mass, or even when it is less than 5 % by mass, polishing rate of SiO₂ film by the polishing composition is not improved significantly. Therefore, it is preferable for the improvement of polishing rate that the content of silica abrasive grains in the polishing composition is greater than or equal to 1 % by mass, and more preferably it is greater than or equal to 5 % by mass. On the other hand, when the content of silica abrasive grains in the polishing composition is more than 40 % by mass, or even when it is more than 20 % by mass, there is a possibility that dispersibility of silica abrasive grains in the polishing composition decreases, and aggregation of silica abrasive grains or gelation of the polishing composition may occur. Therefore, it is preferable for the improvement of dispersibility of silica abrasive grains that the content of silica abrasive grains in the polishing composition is less than or equal to 40 % by mass, and more preferably it is less than or equal to 20 % by mass.

Alkali in the polishing composition plays a role of chemically polishing SiO₂ film, and contributes to improvement of polishing rate of SiO₂ film by the polishing composition.

Alkali contained in the polishing composition is ammonia, ammonium salt, alkali metal salt, or alkali metal hydroxide. Ammonium salt contained in the polishing composition may be ammonium carbonate, and alkali metal salt contained in the polishing composition may be an alkaline metal carbonate. Alkali metal hydroxide contained in the polishing composition may be sodium hydroxide, potassium hydroxide or lithium hydroxide. Meanwhile, when the alkali contained in the polishing composition is a compound other than ammonia, ammonium salt, alkali metal salt and alkali metal hydroxide, such as tetramethylammonium hydroxide (TMAH), the polishing rate of SiO₂ film by the polishing composition is not significantly improved. Therefore, scratches resulting on the surface of SiO₂ film when the SiO₂ film is polished with a polishing composition is greatly increased.

When the content of alkali in the polishing composition is less than 0.01 % by mass, or even when it is less than 0.1 % by mass, the polishing rate of SiO₂ film by the polishing composition is not significantly improved. Therefore, it is preferable for the improvement of polishing rate that the content of alkali in the polishing composition is greater than or equal to 0.01 % by mass, and more preferably it is greater than or equal to 0.1 % by mass. On the other hand, when the content of alkali in the polishing composition is more than 10 % by mass, there is a possibility that silica abrasive grains in the polishing composition may dissolve. Therefore, it is preferable for the prevention of dissolution of silica abrasive grains that the content of alkali in the polishing composition is less than or equal to 10 % by mass.

Silicone oil in the polishing composition has an effect of reducing scratches resulting on the surface of SiO₂ film when the SiO₂ film is polished with the polishing composition. It is inferred that this effect comes from protective coatings formed by silicone oil on the surfaces of silica abrasive grains and the surface of the SiO₂ film. More specifically, it is inferred that when protective coatings are formed by the silicone oil on the surfaces of silica abrasive grains, and as a result aggregation of silica abrasive grains is suppressed and scratches by aggregated silica abrasive grains are suppressed. In addition, it is inferred that when a protective coating is formed by the silicone oil on the surface of the SiO₂ film, scratches by polishing waste are also suppressed by the protective coating.

Silicone oil contained in the polishing composition may be a straight silicone oil or a modified silicone oil. Modified silicone oil includes reactive silicone oil such as amino modified silicone oil, carboxyl modified silicone oil, and heterologous functional group modified silicone oil, and non-reactive silicone oil such as polyether modified silicone oil, higher fatty acid ester modified silicone oil, and hydrophilic specially modified silicone oil. Among all, the silicone oil contained in the polishing composition is preferably a polyether modified silicone oil by which an appropriate HLB (hydrophilic-lipophilic balance) value is easy to be obtained. The polyether modified silicone oil as a silicone oil contained in the polishing composition may be a side-chain type in which a polyoxyalkylene group is introduced in a part of side chains of polysiloxane or a both-end type in which polyoxyalkylene groups are introduced in the both ends of polysiloxane. Alternativley, it may be a single-end type in which a polyoxyalkylene group is introduced in one end of polysiloxane or a side-chain-both-end type in which polyoxyalkylene groups are introduced in a part of side chains of polysiloxane and the both ends of polysiloxane.

When the content of the silicone oil in the polishing composition is less than 1 ppm, or even when it is less than 10 ppm, or yet even when it is less than 100 ppm, scratches resulting on the surface of SiO₂ film when the SiO₂ film is polished with the polishing composition are not significantly reduced. Therefore, it is preferable for reduction of scratches that the content of the silicone oil in the polishing composition is greater than or equal to 1 ppm, more preferably it is greater than or equal to 10 ppm, and the most preferably it is greater than or equal to 100 ppm. On the other hand, there is a possibility that polishing of SiO₂ film may be suppressed by the protective coating of silicone oil formed on the surface of the SiO₂ film when the content of the silicone oil in the polishing composition is more than 10,000 ppm, or even when it is more than 5,000 ppm, or further even when it is more than 1, 000 ppm. And as a result, there is a possibility that polishing rate of SiO₂ film by the polishing composition decreases. Therefore, it is preferable for the prevention of decrease in the polishing rate that the content of silicone oil in the polishing composition is less than or equal to 10,000 ppm, and more preferably it is less than or equal to 5,000 ppm, and the most preferably it is less than or equal to 1,000 ppm.

HLB value of the silicone oil contained in the polishing composition is greater than or equal to 8. When the HLB value of the silicone oil contained in the polishing composition is less than 8, organic residual substances derived from the silicone oil tend to remain as extraneous substances on the surface of SiO₂ film polished with the polishing composition.

But when the HLB value of silicone oil contained in the polishing composition is less than 9, or even when it is less than 10, even in the case that it is greater than or equal to 8, organic residual substances derived from the silicone oil tend to remain as extraneous substances on the surface of SiO₂ film polished with the polishing composition. Therefore, it is preferable for reliably suppressing remaining of extraneous substances on the SiO₂ film that the HLB value of the silicone oil contained in the polishing composition is greater than or equal to 9, and more preferably it is greater than or equal to 10. On the other hand, the polishing composition is easy to cause foaming when the HLB value of the silicone oil contained in the polishing composition is greater than or equal to 16, or even when it is greater than or equal to 12. Therefore, it is preferable for improving defoaming properties of the polishing composition that the HLB value of the silicone oil contained in the polishing composition is less than 16, and more preferably it is less than 12.

It is preferable for effective reduction of defects such as scratches resulting on the surface of SiO₂ film when the SiO₂ film is polished with the polishing composition that the average molecular weight of the silicone oil contained in the polishing composition is 200 to 10,000.

Surface tension of the polishing composition decreases by the addition of silicone oil. The surface tension of the polishing composition is preferably less than 60 mN/m to effectively reduce defects such as scratches resulting on the surface of SiO₂ film when the SiO₂ film is polished with the polishing composition.

According to this embodiment, the following advantages are obtained.

Since the polishing composition of the present embodiment contains silicone oil having an effect of reducing scratches resulting on the surface of SiO₂ film, the polishing composition enables to reduce scratches resulting on the surface of SiO₂ film when the SiO₂ film is polished with the polishing composition. Besides, since the HLB value of silicone oil contained in the polishing composition is greater than or equal to 8, it suppresses formation of organic residue as extraneous substances derived from the silicone oil on the surface of SiO₂ film polished with the polishing composition. In addition, since the polishing composition comprises silica abrasive grains having a role of mechanically polishing SiO₂ film and alkali having a role of chemically polishing SiO₂ film, the polishing composition polish SiO₂ film at a high polishing rate. Therefore, according to the present embodiment, a polishing composition suitable for use in an application for polishing SiO₂ film is provided.

The average particle size of silica abrasive grains contained in the polishing composition is 20 to 100 nm. Therefore, according to the present embodiment, increase of scratches on the surface of SiO₂ film which will occur when the average particle size of silica abrasive grains is less than 20 nm and increase of surface roughness of SiO₂ film which will occur when the average particle size of silica abrasive grains is greater than 100 nm are prevented.

Alkali contained in the polishing composition is not tetramethylammonium hydroxide but ammonia, ammonium salt, alkali metal salt or alkali metal hydroxide. Therefore, scratches resulting on the surface of SiO₂ film will not be greatly increased by the effect of alkali.

The above embodiment may be changed as follows.

Two or more kinds of silica abrasive grains may be contained in the polishing composition of the above embodiment.

Two or more kinds of alkalis may be contained in the polishing composition of the above embodiment.

Two or more kinds of silicone oils may be contained in the polishing composition of the above embodiment. That is, for example, polyether modified silicone oil and silicone oil other than that may be contained in the polishing composition. However, silicone oil contained in the polishing composition is preferably only polyether modified silicone oil since suitable HLB value is easy to be obtained in that composition. In addition, the value of weighted average of HLB values of each silicone oil in the polishing composition must be greater than or equal to 8 when more than two kinds of silicone oil are contained in the polishing composition.

Mildewproofing agents, anticorrosives, defoaming agents, chelating agents, etc. may be added in the polishing composition of the above embodiment if necessary.

The polishing composition of the above embodiment may be used in an application for polishing an object to be polished comprising silicon dioxide other than SiO₂ film.

The polishing composition of the above embodiment may be prepared by diluting a stock solution of the polishing composition with water.

Examples of the present invention and Comparative Examples are described below.

Polishing compositions of Examples 1-21 and Comparative Examples 1-6 were prepared by mixing silica abrasive grains, alkali, polyether modified silicone oil of side-chain type, and water appropriately. Details of silica abrasive grains, alkali, and polyether modified silicone oil in the polishing compositions of Example 1-21 and Comparative Examples 1-6 and surface tensions for the polishing compositions of Examples 1-9 and Comparative Examples 1-3 are as shown in Table 1. Here, surface tension for each polishing composition was measured under measurement conditions shown in Table 2.

The "polishing rate" column of Table 1 shows polishing rates obtained when an SiO₂ blanket wafer (a wafer with a TEOS film) having a diameter of 200 mm is polished with each of the polishing compositions of Examples 1-21 and Comparative Examples 1-6 under polishing conditions shown in Table 3. The polishing rate was determined by dividing the difference in the thickness of each wafer before and after polishing by the polishing time. Film thickness measuring apparatus "VM2030" of Dainippon Screen Mfg. Co., Ltd. was used for the measurement of a thickness of a wafer.

In the "surface defects" column of Table 1, results of evaluating surface defects of SiO₂ blanket wafers polished under polishing conditions shown in Table 3 using each of the polishing compositions of Examples 1-21 and Comparative Examples 1-6 are shown. Specifically, SiO₂ blanket wafers polished with each of the polishing compositions were washed with 0.5 % by mass hydrofluoric acid solution for 12 seconds, and subsequently the number of scratches and extraneous substances having a size greater than or equal to 0.2 µm present on the surface of SiO₂ blanket wafer was measured using wafer tester "SURFSCAN SP1-TBI" of KLA-Tencor Corporation. In the "surface defects" column, "1" (excellent) shows that the number of scratches and extraneous substances having a size greater than or equal to 0.2 µm was less than 10, "2"(good) shows that the number was not less than 10 and less than 30, "3"(slightly poor) shows that the number was not less than 30 and less than 50 and "4" (poor) shows that the number was not less than 50.

In the "defoaming properties" column of Table 1, results of evaluating defoaming properties of each of the polishing compositions of Examples 1-21 and Comparative Examples 1-6 are shown. Specifically, about 80 mL each of the polishing compositions was put in glass vessels having a volume of 100 mL and shaken for 10 seconds and the length of time needed after shaking before foams almost disappeared in the polishing composition was measured. In the "defoaming properties" column, "1" (excellent) shows that the length of time before foams disappeared was less than 1 minute, "2" (good) shows that the length of time was not less than 1 minute and less than 5 minutes, "3"(slightly poor) shows that the length of time was not less than 5 minutes and less than 10 minutes and "4" (poor) shows that the length of time was not less than 10 minutes.

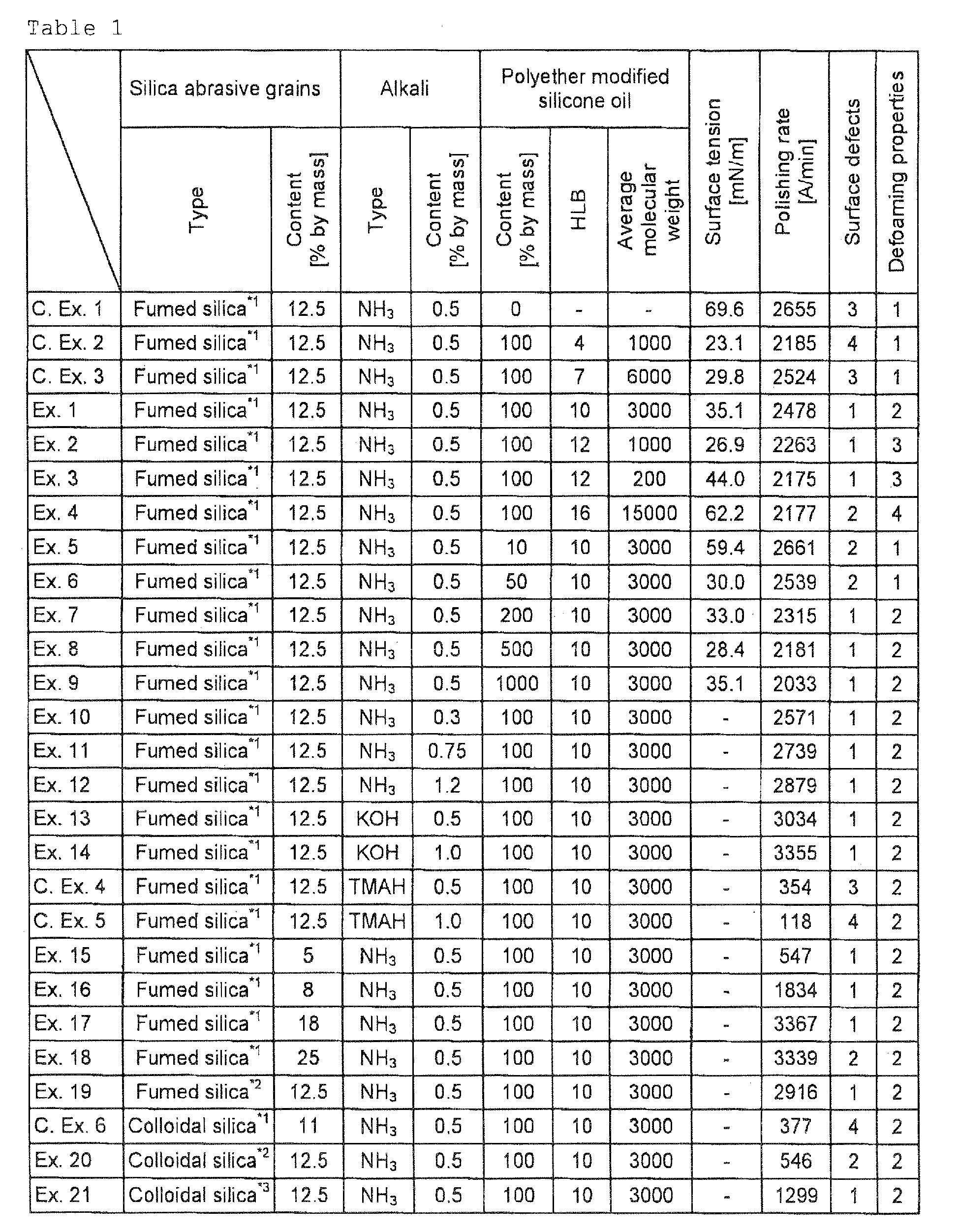

In "Silica abrasive grains" column of Table 1, "Fumed silica^{*1}" represents fumed silica having an average particle size of 30 nm and "Fumed silica^{*2"} represents fumed silica having an average particle size of 50 nm, and "Colloidal silica^{*1}" represents colloidal silica having an average particle size of 10 nm, "Colloidal silica^{*2}" represents colloidal silica having an average particle size of 30 nm and "Colloidal silica^{*3}" represents colloidal silica having an average particle size of 90 nm.

**Table 2**

| |
|---|
| Measuring apparatus: Automatic surface tension meter "CBVP-Z" of Kyowa InterFace Science Co., Ltd. |
| Measuring method: Plate method |
| Probe: Platinum plate |
| Measurement temperature: 25°C |

**Table 3**

| |
|---|
| Polishing device: CMP device "EPO-113D" of Ebara Corporation |
| Polishing load: 34.5 kPa (5.0 psi) |
| Polishing linear velocity: 42 m/min |
| Polishing time: 30 seconds |
| Flow rate of polishing composition: 200 mL/min |

As shown in Table 1, the results obtained for the polishing compositions of Examples 1-21 were practically satisfactory with regard to polishing rate and surface defects. In contrast, no practically satisfactory results were obtained in Comparative Examples 1-6 at least with regard to surface defects. In addition, it turned out from the results of Examples 1-4 that good results were obtained with regard to defoaming properties when the HLB value of polyether modified silicone oil contained in the polishing composition was less than 16, or even it was less than 12.

## Claims

1. A polishing composition used in an application for polishing an object to be polished comprising silicon dioxide, the polishing composition **characterized by** containing:
silica abrasive grains having an average particle size of 20 to 100 nm;
an alkali selected from the group consisting of ammonia, ammonium salts, alkali metal salts, and alkali metal hydroxides; and
a silicone oil having an HLB value greater than or equal to 8.

2. The polishing composition according to claim 1, **characterized in that** the molecular weight of the silicone oil is 200 to 20,000.

3. The polishing composition according to claim 1 or 2, **characterized in that** the silicone oil is a polyether modified silicone oil.

4. A polishing method **characterized by** polishing an object to be polished comprising silicon dioxide using the polishing composition according to any one of claims 1 to 3.
